# EUROPÄISCHE PATENTSCHRIFT

(11) **EP 1 594 814 B1**
(45) Veröffentlichungstag und Bekanntmachung des Hinweises auf die Patenterteilung: **24.11.2010**
(21) Anmeldenummer: 04705803.7
(22) Anmeldetag: 28.01.2004
(51) Int. Cl.: C04B 35/117, C04B 35/50, C23C 14/08, C03C 17/34, C03C 17/245, G02B 1/10

(54) **AUFDAMPFMATERIAL ZUR HERSTELLUNG MITTELBRECHENDER OPTISCHER SCHICHTEN**
EVAPORATION MATERIAL FOR THE PRODUCTION OF AVERAGE REFRACTIVE OPTICAL LAYERS
MATERIAU DE DEPOT PAR EVAPORATION POUR PRODUIRE DES COUCHES A INDICE DE REFRACTION OPTIQUE MOYEN

(30) Priorität: 19.02.2003 DE 10307096
(43) Veröffentlichungstag der Anmeldung: 16.11.2005
(73) Patentinhaber: Merck Patent GmbH, 64293 Darmstadt (DE)
(72) Erfinder: FRIZ, Martin, 64297 Darmstadt (DE); DOMBROWSKI, Reiner, 64739 Höchst (DE); ANTHES, Uwe, 64711 Erbach (DE)
(86) Internationale Anmeldenummer: PCT/EP2004/000719
(87) Internationale Veröffentlichungsnummer: WO 2004/074206

(56) Entgegenhaltungen:
- US-A- 5 157 547
- US-A- 6 087 014
- PATENT ABSTRACTS OF JAPAN vol. 2000, no. 09, 13. Oktober 2000 (2000-10-13) -& JP 2000 171609 A (OPUTORON:KK;CANON INC), 23. Juni 2000 (2000-06-23) in der Anmeldung erwähnt
- SHIMODA T ET AL: "Fabrication of highly ytterbium (Yb)-doped YAG thin film by pulsed laser deposition" OPTICS COMMUNICATIONS, NORTH-HOLLAND PUBLISHING CO. AMSTERDAM, NL, Bd. 194, Nr. 1-3, 1. Juli 2001 (2001-07-01), Seiten 175-179, XP004248440 ISSN: 0030-4018
- KIMURA H. ET AL.: "Solid-State Synthesis of Dy3Al5O12 Using Dy2O3 and Al2O3 Powders" JOURNAL OF THE JAPANESE INSTITUTE OF METALS, Bd. 60, Nr. 3, März 1996 (1996-03), Seiten 295-300, XP009028573
- NODEN J. D.: "Gadolinium Burnable Poison for High Temperature Reactors" NUCL. ENG. INT. , Bd. 18, Nr. 207, August 1973 (1973-08), Seiten 641-646, XP009028571

## Beschreibung

Die Erfindung betrifft die Vervendung eines Aufdampfmaterial zur Erzeugung mittelbrechender optischer Schichten, welches Aluminiumoxid und Gadoliniumoxid, Dysprosiumoxid und/oder Ytterbiumoxid enthält, ein Verfahren gemäss Anspruch 8, ein Aufdampfmaterial gemäss Anspruch 12, eine optische Schicht gemäss Anspruch 14 und ein mehrlagiges optisches system gemäss Anspruch 15. Zum Schutz der Oberflächen oder zur Erzielung bestimmter optischer Eigenschaften werden optische Bauteile in der Regel mit dünnen Beschichtungen versehen.
Zu diesen optischen Bauteilen gehören beispielsweise optische Linsen, Brillengläser, Objektive für Kameras, Ferngläser oder für andere optische Geräte, Strahlteiler, Prismen, Spiegel, Fensterscheiben und ähnliches.

Die Beschichtungen können zur Vergütung der genannten Oberflächen durch Härtung und/oder Erhöhung der chemischen Resistenz gegen Schädigungen durch mechanische, chemische oder Umwelteinflüsse eingesetzt werden, In vielen Fällen ist das Ziel solcher Oberflächenvergütungen jedoch eine verminderte Reflexion, was insbesondere für Brillengläser, Objektiv und dergleichen zutrifft. Es gibt aber auch Anwendungsfälle, bei denen eine erhöhte Reflexion erwünscht ist oder auch optische Schichten, die definierte Brechzahlen oder Absorptionseigenschaften aufweisen müssen, wie beispielsweise für die Herstellung von Interferenzspiegeln, Strahlteilern, Wärmefiltern oder Kaltlichtspiegeln. Die optimalen Eigenschaften der Schichten werden im allgemeinen durch Auswahl geeigneter Beschichtungsmaterialien, verschiedener Schichtdicken und ein- oder mehrschichtiger Schichtaufbauten aus gegebenenfalls unterschiedlichen Materialien mit verschiedenen Brechzahlen eingestellt. So kann beispielsweise bei reflexionsvermindernden Beschichtungen eine Reduktion der Reflexion auf unter 1 % über das gesamte sichtbare Strahlungsspektrum erzielt werden.

Es ist bekannt, dass die oben genannten Vergütungsschichten durch das Aufbringen dünner Schichten aus verschiedenen Materialien, insbesondere aus Oxiden wie SiO₂, TiO₂, ZrO₂, MgO, Al₂O₃, aber auch aus Fluoriden wie MgF₂ sowie Gemischen dieser Stoffe erzeugt werden können.

Die Auswahl der Beschichtungsmaterialien erfolgt dabei nach den angestrebten optischen Eigenschaften und nach der Verarbeitbarkeit der Materialien.

Die Beschichtung von optischen Substraten wird üblicherweise mit einem Hochvakuumaufdampfverfahren durchgeführt. Hierbei wird zunächst das Substrat und eine die Aufdampfsubstanz enthaltende Vorlage in einer geeigneten Hochvakuumaufdampfapparatur platziert, anschließend die Apparatur evakuiert und die Aufdampfsubstanz durch Erhitzen und/oder Elektronenstrahlbeschuss zur Verdampfung gebracht, wobei sich das Aufdampfmaterial als dünne Schicht auf der Substratoberfläche niederschlägt. Entsprechende Apparaturen und Verfahren sind gängiger Stand der Technik.

Es ist nur eine begrenzte Auswahl an Stoffen bekannt, welche sich für die Herstellung mittelbrechender Schichten, die in der Regel eine Brechzahl zwischen 1,6 und 1,9 aufweisen, eignen. Als Ausgangsmaterialien werden beispielsweise die Oxide von Aluminium, Magnesium, Yttrium, Lanthan und Praseodym, aber auch Cerfluorid, Lanthanfluorid oder Gemische aus diesen eingesetzt.
Als bevorzugtes Ausgangsmaterial für die Erzeugung mittelbrechender Schichten wird jedoch Aluminiumoxid verwendet.

Obwohl diese Materialien an sich für die Herstellung mittelbrechender Schichten geeignet sind, weisen sie eine Reihe von Nachteilen auf, die ihre praktische Anwendung erschweren.

So haben diese Substanzen beispielsweise hohe Schmelz- und Siedepunkte, die oft auch dicht beieinander liegen. Zur Verbesserung der Anwendbarkeit ist es aber notwendig, dass das Ausgangsmaterial vor Beginn der Verdampfung vollständig geschmolzen ist, da nur so eine gleichmäßige und ausreichende Abdampfrate gewährleistet werden kann. Diese ist Vorraussetzung für das Abscheiden von homogenen und gleichmäßig dicken Schichten.

Magnesiumoxid und Yttriumoxid schmelzen aber unter den üblichen Arbeitsbedingungen nicht vollständig ein und sind ,beispielsweise durch die Sublimierungsneigung des Yttriumoxids, insgesamt schwer zu verdampfen, so dass die damit erzeugten Schichten in der Regel Schichtdickenschwankungen aufweisen.
Mit Magnesiumoxid und Lanthanoxid werden beim Aufdampfen poröse Schichten gebildet, die Feuchtigkeit aufnehmen und damit instabil werden. Außerdem bindet MgO aus feuchter Luft CO₂ in Form von Carbonat. Auch Cerfluorid und Lanthanfluorid bilden inhomogene Schichten aus, die nicht über die nötige Härte und Haltbarkeit verfügen.

Für spezielle Anwendungsfälle, in denen Brechzahlen zwischen 1,7 und 1,8 gefordert sind, können beispielsweise Aluminiumoxid (n=1,63) und Yttriumoxid (n=1,85) in reiner Form nicht eingesetzt werden.

Aus diesem Grunde gab es zahlreiche Bestrebungen, durch geeignete Zusätze den Schmelzpunkt der Grundmaterialien herabzusetzen. Gleichzeitig kann durch die Zugabe von Zusätzen auch eine gezielte Einstellung der Brechzahl erfolgen.
Bei der Auswahl der zuzusetzenden Materialien muß jedoch beachtet werden, dass nur solche Materialien in Frage kommen, die in einem breiten Bereich des Strahlungsspektrums keine oder keine nennenswerte Absorption aufweisen. Von besonderer Bedeutung ist hier eine Absorptionsfreiheit vom nahen infraroten über den sichtbaren Spektralbereich bis in den nahen UV-Wellenlängenbereich (bis ca. 200 nm). Daher sind beispielsweise Praseodymoxid und Neodymoxid als Zusätze nicht geeignet, da sie in diesem Bereich Absorptionsmaxima aufweisen.

Der Einsatz von Mischsystemen erweist sich aber auch aus anderen Gründen als schwierig, da Mischsysteme in vielen Fällen inkongruent verdampfen, d.h. ihre Zusammensetzung im Verlaufe des Verdampfungsprozesses verändern. Damit verändert sich aber auch die Zusammensetzung der abgeschiedenen Schichten. Die entstehenden inhomogenen Schichten weisen keine reproduzierbare einheitliche Brechzahl mehr auf. Dieses Problem tritt verstärkt in Erscheinung, wenn, wie allgemein üblich, Schichtsysteme aus mehreren Schichten auf einem Substrat aufgebracht werden.

Aus der US 3,934,961 ist eine dreilagige Antireflexionsbeschichtung bekannt, deren erste Schicht auf dem Substrat aus Aluminiumoxid und Zirkoniumoxid besteht. Damit sind mittelbrechende Schichten zwischen 1,63 und 1,75 einstellbar. Zwar zeigen solche Schichten im sichtbaren Spektralbereich keine Absorptionen, jedoch hat sich in der Praxis gezeigt, dass die Metalloxide inkongruent verdampfen und damit zu inhomogenen Schichten führen.

In der DE-OS 42 19 817 wird ein Aufdampfmaterial zur Herstellung mittelbrechender optischer Schichten beschrieben, welches aus einer Verbindung der Formel La₁₋ₓ Al₁₊ₓ O₃ mit x= 0 bis 0,84 besteht. Diese Verbindung wird aus einer Mischung aus Lanthanoxid und Aluminiumoxid hergestellt. Durch den Anteil an Lanthanoxid tritt jedoch eine erhöhte Empfindlichkeit gegenüber einer feuchten Atmosphäre auf, da Lanthanoxid Feuchtigkeit aufnimmt. Allein um die damit verbundenen Verarbeitungsprobleme zu vermindern, müssen deshalb bereits bei der Herstellung und später bei der Verarbeitung der Aufdampfmaterialien aufwändige Maßnahmen ergriffen werden. Die entstehenden Schichten sind jedoch in jedem Falle bei erhöhter Luftfeuchtigkeit nicht stabil. Außerdem besitzt Lanthan ein natürliches radioaktives Isotop, welches als Gammastrahler wirkt und in optischen Schichten, die aus der oben genannten Verbindung hergestellt sind, Störungen und Schädigungen an empfindlichen Bauelementen, z. B. Detektoren, hervorrufen kann. Ein weiterer Nachteil besteht darin, dass das Gemisch vor dem Verdampfen Sintertemperaturen von 1600°C und höher ausgesetzt werden muß, welche Schädigungen an den verwendeten Gerätschaften und Apparaturen, beispielsweise an Schmelztiegeln und Heizwendeln, hervorrufen können.

Gemäß der japanischen Offenlegungsschrift JP-A-2000-171609 wird eine Verbindung der Formel Sm₁₋ₓAl₁₊ₓO₃ mit -1 <x<1 zur Herstellung mittelbrechender Schichten verwendet. Dieses Material verändert seine Zusammensetzung während des Verdampfens nicht, weist jedoch bei einer Wellenlänge von etwa 400 nm eine Absorptionsbande durch das Samarium-lon auf, welche die Anwendung über den sichtbaren Spektralbereich hinaus insbesondere im ultravioletten Spektralbereich einschränkt. Außerdem besitzt auch Samarium natürliche radioaktive Isotope, die mit einer hohen relativen Häufigkeit von 15% auftreten und als Alphastrahler ebenfalls die bereits oben beschriebenen Nachteile aufweisen. Um das Gemisch zu sintern, sind Temperaturen von etwa 1500°C erforderlich.

Weitere Oxide von Elementen aus der Gruppe der Lanthanoiden werden als Einzelsubstanzen in optischen Schichten eingesetzt.

So wird beispielsweise in der US 4,794,607 ein Halbleiterlaser beschrieben, welcher eine Antireflexionsschicht aus Gadoliniumoxid besitzen kann. Eine dünne Zwischenschicht aus Aluminiumoxid verstärkt die Haftung der Gadoliniumoxidschicht am Laser. Welche Brechzahl mit der Gadoliniumoxidschicht erzielt werden kann, ist nicht beschrieben.

Aus der DE-OS 33 35 557 ist eine Kunstharzlinse mit einer Brechzahl von etwa 1,6 bekannt, welche in einem Mehrschichtsystem zur Reflexionsverminderung Ytterbiumoxid in einer Schicht enthalten kann. Welche Brechzahl mit dieser Ytterbiumoxidschicht erzielt werden kann wird nicht erwähnt. Mischungen von Ytterbiumoxid mit anderen Materialien sind nicht beschrieben.

Die Aufgabe der vorliegenden Erfindung bestand nun darin, ein Aufdampfmaterial zur Herstellung mittelbrechender optischer Schichten zur Verfügung zu stellen, welches eine hohe Haltbarkeit aufweist, gegen Feuchtigkeit, Säuren und Alkalien wenig empfindlich ist, eine geringe Radioaktivität besitzt, über einen breiten Spektralbereich transparent und nicht absorbierend ist, beim Einschmelzen und Verdampfen seine ursprüngliche Zusammensetzung nicht verändert, nur niedrige Sintertemperaturen benötigt und mit Hilfe dessen mittelbrechende Schichten mit den oben genannten Eigenschaften erhalten werden können, deren Brechzahl im Bereich zwischen 1,7 und 1,8 gezielt eingestellt werden kann.

Die erfindungsgemäße Aufgabe wird durch ein Aufdampfmaterial zur Herstellung mittelbrechender optischer Schichten, enthaltend Aluminiumoxid und mindestens zwei Verbindungen aus der Gruppe bestehend aus Gadoliniumoxid, Dysprosiumoxid und Ytterbiumoxid, gelöst.

Die erfindungsgemäße Aufgabe wird auch durch ein Verfahren zur Herstellung eines Aufdampfmaterials zur Erzeugung mittelbrechender optischer Schichten gelöst, wobei Aluminiumoxid mit Ytterbiumoxid und Gadoliniumoxid und/oder Dysprosiumoxid gemischt, die Mischung komprimiert oder suspendiert, geformt und anschließend gesintert wird.

Darüber hinaus ist die Verwendung eines Aufdampfmaterials enthaltend Aluminiumoxid und mindestens eine Verbindung aus der Gruppe bestehend aus Gadoliniumoxid, Dysprosiumoxid und Ytterbiumoxid zur Herstellung mittelbrechender optischer Schichten, optische Schichten gemäß Anspruch 14 und ein mehrlagiges optisches System gemäß Anspruch 15 Gegenstand der vorliegenden Erfindung.

Das erfindungsgemäß zu verwendende Aufdampfmaterial enthält Aluminiumoxid und mindestens eine Verbindung aus der Gruppe bestehend aus Gadoliniumoxid (Gd₂O₃), Dysprosiumoxid (Dy₂O₃) und Ytterbiumoxid (Yb₂O₃). Das Aufdampfmaterial gemäß Anspruch 12 enthält Aluminiumoxid und mindestens zwei Verbindung aus der genannten Gruppe. Die molare Zusammensetzung des Gemisches bestimmt dabei die Brechzahl der Schicht, die mittels des Aufdampfmaterials hergestellt werden kann. Reines Aluminiumoxid führt zu einer Brechzahl der Schicht von etwa 1,63. Dies ist für bestimmte Anwendungen zu niedrig, bei denen Brechzahlen von 1,7 bis 1,8 erforderlich sind. Die Brechzahlen von reinen Schichten aus Gadoliniumoxid, Dysprosiumoxid oder Ytterbiumoxid schwanken je nach Schichtdicke und Auftragsverfahren zwischen 1,55 und 1.85. Durch Zugabe dieser Substanzen kann also in den meisten Fällen die Brechzahl gegenüber einer Schicht aus reinem Aluminiumoxid erhöht werden.

Die molare Zusammensetzung des Gemisches wird daher entsprechend der erforderlichen Brechzahl eingestellt. Sie ist in breiten Grenzen varüerbar und beträgt 1:99 bis 99:1 (Mol. %) bei binären Gemischen. Werden mehrere Verbindungen aus der Gruppe bestehend aus Gadoliniumoxid, Dysprosiumoxid und Ytterbiumoxid eingesetzt, kann jeder der Bestandteile bei ternären Gemischen mit bis zu 98 Mol. % enthalten sein, bei quaternären Gemischen mit bis zu 97 Mol. %.

Dabei Ist ein Anteil von 20 bis 80 Mol. % Aluminiumoxid und von 80 bis 20 Mol.% der mindestens einen Verbindung aus der Gruppe bestehend aus Gadoliniumoxid, Dysprosiumoxid und Ytterbiumoxid besonders vorteilhaft, insbesondere jedoch ein Verhältnis von 40:60 bis 60:40.

Neben einer zuverlässigen Einstellbarkeit der gewünschten Brechzahl, bevorzugt im Bereich zwischen 1,7 und 1,8, bietet dieses Gemisch auch einen nicht unbeachtlichen ökonomischen Vorteil gegenüber reinen Schichten aus Gadoliniumoxid, Dysprosiumoxid oder Ytterbiumoxid, da Aluminiumoxid besser verfügbar und kostengünstiger ist.

Der Einsatz von ternären oder quaternären Gemischen aus Aluminiumoxid und Gadoliniumoxid und/oder Dysprosiumoxid und/oder Ytterbiumoxid kann eine exakte Steuerung der Brechzahl begünstigen. Damit erhöht sich die Variationsbreite der einstellbaren mittleren Brechzahlen im Bereich von 1,6 bis 1,9.

Neben der Möglichkeit, Schichten mit Brechzahlen in einem vordefinierten Bereich erzeugen zu können, besitzen die erfindungsgemäßen Aufdampfmaterialien noch eine Reihe weiterer Vorteile. Obwohl es sich um Gemische handelt, verdampfen diese kongruent, d.h. ihre Zusammensetzung ändert sich während des Verdampfungsprozesses praktisch nicht. Damit können homogene Schichten mit einer mittleren Brechzahl reproduzierbar hergestellt werden. Dies ist insbesondere dann von Vorteil, wenn Mehrschichtsysteme mit Materialien aus verschiedenen Brechzahlen übereinander abgeschieden werden. Über die Anzahl der Schichten mit mittlerer Brechzahl würde sich anderenfalls eine größere Abweichung vom ursprünglich berechneten Systemwert ergeben.

Die erhaltenen optischen Schichten sind über einen breiten Spektralbereich, d.h. von etwa 250 nm bis etwa 7 µm, transparent und weisen in diesem Bereich nur eine äußerst geringe Absorption auf. Speziell im sichtbaren Spektralbereich sind sie völlig absorptionsfrei. Dies macht sie insbesondere für die Anwendung in polarisierenden Strahlteilern und dichroitischen Filtern interessant.

Weiterhin weist das erfindungsgemäße Aufdampfmaterial eine verbesserte Haltbarkeit auf, die sich vorwiegend in feucht-warmer Umgebung positiv auswirkt. Da die Ausgangsmaterialien stabil gegen Luftfeuchtigkeit sind, ist ihre Handhabung einfach und besondere Schutzmaßnahmen bei der Herstellung und Weiterverarbeitung der Aufdampfmaterialien müssen nicht ergriffen werden. Desgleichen zeichnen sich die mit diesen Materialien hergestellten optischen Schichten durch eine hohe Stabilität in feucht-warmer Atmosphäre sowie gegenüber Säuren und Alkalien aus.

Ein weiterer Vorteil der Aufdampfmaterialien der vorliegenden Erfindung liegt darin, dass die verwendeten Substanzen keine radioaktiven Isotope aufweisen. Weder die Aufdampfmaterialien selbst noch die damit hergestellten Schichten strahlen daher radioaktiv, so dass Vorsichtsmaßnahmen unterbleiben können und eine diesbezügliche Schädigung von optischen Bauelementen oder Detektoren, welche mit den Schichten in Verbindung kommen, nicht zu erwarten ist.

Das erfindungsgemäß zu verwendende Aufdampfmaterial wird hergestellt, indem Aluminiumoxid mit mindestens einer Verbindung aus der Gruppe bestehend aus Gadoliniumoxid, Dysprosiumoxid und Ytterbiumoxid gemischt, die Mischung komprimiert oder suspendiert, geformt und anschließend gesintert wird. Gemäß Anspruch 8 wird Aluminiumoxid mit Ytterbiumoxid und Gadoliniumoxid und/oder Dysprosiumoxid gemischt und wie beschrieben weiter verarbeitet.

Das molare Mischungsverhältnis der Ausgangskomponenten ist abhängig von der zu erzielenden Brechzahl der mit der Mischung aufzubringenden Schicht und kann in einem breiten Bereich variiert werden, nämlich von 1:99 bis 99:1 Mol. % bei binären Gemischen und mit einem Anteil von bis zu 98 Mol. % für eines der Oxide bei einem ternären und bis zu 97 Mol. % bei einem quaternären Gemisch.

Ein Anteil von 20 bis 80 Mol. % Aluminiumoxid und von 80 bis 20 Mol.% der mindestens einen Verbindung aus der Gruppe bestehend aus Gadoliniumoxid, Dysprosiumoxid und Ytterbiumoxid ist besonders vorteilhaft, insbesondere jedoch ein Verhältnis von 40:60 bis 60:40. Die Komponenten werden innig miteinander vermischt und anschließend mittels geeigneter, an sich bekannter Maßnahmen der Komprimierung verdichtet und geformt. Es kann jedoch auch eine Suspension der gemischten Komponenten in einem geeigneten Trägermedium hergestellt werde, welche geformt und anschließend getrocknet wird. Ein geeignetes Trägermedium ist beispielsweise Wasser, welchem je nach Bedarf Bindemittel wie Polyvinylalkohol, Methylzellulose oder Polyethylenglykol sowie gegebenenfalls Hilfsmittel, wie z.B. Netzmittel oder Entschäumer, zugesetzt werden. Nach dem Suspendieren erfolgt eine Formgebung. Hierbei können verschiedene bekannte Techniken, wie Strangpressen, Spritzgießen oder auch Sprühtrocknen Anwendung finden. Die erhaltenen Formen werden getrocknet und vom Bindemittel, beispielsweise durch Ausbrennen, befreit. Dies erfolgt aus Gründen einer besseren Handhabbarkeit und Dosierbarkeit der Mischungen, die damit auch kontinuierlichen Aufdampfprozessen zugänglich werden. Daher sind die Formen, in welche das Gemisch gebracht wird, nicht limitiert. Geeignet sind alle Formen, welche eine einfache Handhabung und eine gute Dosierbarkeit ermöglichen, die insbesondere bei der kontinuierlichen Beschichtung von Substraten mit dem erfindungsgemäßen Aufdampfmaterial und dem dafür nötigen Nachfüllprozeß eine besondere Rolle spielen. Bevorzugte Formen sind daher verschiedene Tablettenformen, Pellets, Scheiben, Kegelstümpfe, Körner bzw. Granulate, Stangen oder auch Kugeln.

Anschließend werden die geformten Gemische gesintert. Der Sinterprozeß kann dabei unter verschiedenen Bedingungen durchgeführt werden. In der Regel wird das erfindungsgemäße Aufdampfmaterial an Luft gesintert. Der Sinterprozeß kann jedoch auch im Vakuum oder unter Inertgas, z. B. Argon, stattfinden. Von besonderem Vorteil ist, dass die benötigten Sintertemperaturen zum Teil erheblich niedriger liegen als bei anderen geeigneten Aufdampfmaterialien für mittelbrechende Schichten aus dem Stand der Technik. Sie betragen etwa 1300 bis 1600°C an Luft oder im Vakuum oder Inertgas. Diese vergleichsweise niedrigen Temperaturen führen zu einer geringeren thermischen Belastung der Gerätschaften und Apparaturen, wie beispielsweise Schmelztiegeln und Heizwendeln, so dass deren Lebensdauer erhöht ist.

Die entstehenden geformten Sinterprodukte bleiben in ihrer Form beim Lagern, Transportieren und beim Einfüllen in die Verdampfungsapparatur bestehen und sind in ihrer Zusammensetzung während des gesamten nachfolgenden Aufschmelz- und Verdampfungsprozesses stabil.

Nach dem Sintern und Abkühlen sind die erfindungsgemäßen Aufdampfmaterialien anwendungsbereit zur Herstellung von mittelbrechenden optischen Schichten mit Brechzahlen zwischen 1,6 und 1,9.

Mit den Aufdampfmaterialien gemäß der vorliegenden Erfindung lassen sich alle geeigneten Substrate beschichten, die aus den bekannten geeigneten Materialien, wie beispielsweise verschiedenen Gläsern oder Kunststoffen bestehen können und in Form von Scheiben, Prismen, Folien, geformten Substraten wie Linsen, Brillengläsern, Objektive oder ähnlichem vorliegen. Deren Art, Größe, Form, Material und Oberflächenbeschaffenheit ist nicht limitiert und wird lediglich durch die Anwendbarkeit der Substrate in der Beschichtungsapparatur beschränkt, da die Substrate in die Apparatur eingebracht werden können und bei den dort herrschenden Temperatur- und Druckverhältnissen stabil bleiben müssen.
Es hat sich als vorteilhaft erwiesen, die Substrate vor und während des Beschichtens zu erwärmen, so dass das Aufdampfmaterial auf ein vorgeheiztes Substrat trifft. Diese Maßnahme ist jedoch an sich aus dem Stand der Technik bekannt.

Als Aufdampfverfahren wird üblicherweise ein Hochvakuumaufdampfverfahren eingesetzt, bei welchem das Aufdampfmaterial in einer geeigneten Vorlage, die als Verdampfungstiegel oder Verdampfungsschiffchen bezeichnet wird, zusammen mit dem zu beschichtenden Substrat in eine Vakuumapparatur eingebracht wird.

Nachfolgend wird die Apparatur evakuiert und das Aufdampfmaterial durch Erhitzen und/oder Elektronenstrahlbeschuß zur Verdampfung gebracht. Dabei schlägt sich das Aufdampfmaterial als dünne Schicht auf dem Substrat nieder.

Während der Verdampfung kann Sauerstoff zugesetzt werden, um die volle Oxidation der Schichten zu gewährleisten. Weiterhin kann zur Erhöhung der Dichte der Schichten und zur Verbesserung der Haftung insbesondere auf ungeheizten Substraten während der Beschichtung ein lonenbeschuss des Substrates vorgenommen werden (Ion Assisted Deposition, Plasma Assisted Deposition).

Häufig werden abwechselnd mehrere Schichten übereinander auf dem Substrat abgeschieden. Durch geeignete Auswahl der Brechzahlen der einzelnen Schichten lassen sich dadurch die gewünschten optischen Eigenschaften gezielt einstellen, wie beispielsweise Peflexionsemiedrigung, Reflexionserhöhung oder die Einstellung einer vordefinierten Brechzahl für das Gesamtsystem. Solche mehrlagigen Anordnungen auf optischen Substraten an sich sind jedoch seit langem bekannt und werden häufig angewendet.

Mit dem erfindungsgemäßen Aufdampfmaterial lassen sich haftfeste mittelbrechende optische Schichten auf geeigneten Substraten herstellen, welche in einem breiten Spektralbereich nicht absorbierend, transparent und homogen sind, eine mittlere Brechzahl im Bereich von etwa 1,6 bis etwa 1,9 aufweisen, in feucht-warmer Umgebung und gegen Säuren und Alkalien stabil sind und keine radioaktive Strahlung abgeben.

Die Erfindung soll nachfolgend durch mehrere Beispiele erläutert werden, ohne sie jedoch darauf zu beschränken.

### Beispiel 1:

### Mischung aus Al₂O₃ und Dy₂O₃

21,11 g Aluminiumoxid (50 Mol. %) und 77,21 g Dysprosiumoxid (50 Mol. %) werden innig miteinander vermischt, bis ein homogenes Gemisch entstanden ist. Dieses Gemisch wird zu Tabletten geformt, welche an Luft bei 1300 °C 4 Stunden lang geglüht werden. Nach dem Abkühlen werden die Tabletten in den Tiegel einer Elektronenstrahl- Verdampfereinrichtung, beispielsweise in eine Anlage vom Typ A700Q der Fa. Leybold, eingebracht. In die Substrathaltevorrichtung der Anlage werden gereinigte Substrate aus Quarzglas und Brillenkronglas BK7 eingesetzt. Die Anlage wird auf einen Druck von 2x10⁻³ Pa evakuiert. Die Substrate werden auf etwa 300 °C aufgeheizt. Danach wird Sauerstoff bis zu einem Druck von 2x10⁻² Pa in die Anlage eingelassen, um eine vollständige Oxidation zu erzielen. Die Tablette aus dem Aufdampfmaterial wird anschließend auf die Verdampfungstemperatur von etwa 2100 °C aufgeheizt und eine Schicht mit einer Dicke von etwa 280 nm auf die Substrate aufgedampft. Die Schichtdicke wird mit einem Schwingquarz-Schichtdickenmeßgerät bestimmt. Nach dem Abkühlen der Anlage wird mit Luft geflutet und die beschichteten Substrate werden entnommen. Mit einem Spektralphotometer werden die Transmissions- und Reflexionsspektren gemessen und aus diesen die Schichtdicke und die Brechzahl rechnerisch ermittelt. Die aufgebrachten Schichten sind homogen und weisen bei einer Wellenlänge von 500 nm eine Brechzahl von 1,70 auf. Die Absorption im Bereich von 300 bis 900 nm wird mit kleiner als 1 % festgestellt.

### Beispiel 2:

### Mischung aus Al₂O₃ und Yb₂O₃

20,11 g Aluminiumoxid (50 Mol. %) und 81,57 g Ytterbiumoxid (50 Mol. %) werden innig miteinander vermischt, bis ein homogenes Gemisch entstanden ist. Dieses Gemisch wird zu Tabletten geformt, welche an Luft bei 1300 °C 4 Stunden lang geglüht werden. Die abgekühlten Tabletten werden anschließend in den Tiegel einer Elektronenstrahl- Verdampfereinrichtung, beispielsweise in eine Aufdampfanlage vom Typ A700Q der Fa. Leybold eingebracht. In die Substrathaltevorrichtung der Anlage werden gereinigte Substrate aus Quarzglas und Brillenkronglas BK7 eingesetzt. Die Anlage wird auf einen Druck von 2x10⁻³ Pa evakuiert. Die Substrate werden auf etwa 300 °C aufgeheizt. Danach wird Sauerstoff bis zu einem Druck von 2x10⁻² Pa in die Anlage eingelassen. Die Tablette aus dem Aufdampfmaterial wird anschließend auf die Verdampfungstemperatur von 2100 °C aufgeheizt und eine Schicht mit einer Dicke von etwa 280 nm auf die Substrate aufgedampft. Nach dem Abkühlen der Anlage wird mit Luft geflutet und die beschichteten Substrate werden entnommen. Mit einem Spektralphotometer werden die Transmissions- und Reflexionsspektren gemessen und aus diesen die Schichtdicke und die Brechzahl rechnerisch ermittelt. Die aufgebrachten Schichten sind homogen und weisen bei einer Wellenlänge von 500 nm eine Brechzahl von 1,76 auf. Die Absorption im Bereich von 300 bis 900 nm wird mit kleiner als 1 % festgestellt.

### Beispiel 3:

### Mischung aus Al₂O₃ und Gd₂O₃

21,56 g Aluminiumoxid (50 Mol. %) und 76,67 g Gadoliniumoxid, (50 Mol. %) werden innig miteinander vermischt, bis ein homogenes Gemisch entstanden ist. Dieses Gemisch wird zu Tabletten geformt, welche an Luft bei 1300 °C 4 Stunden lang geglüht werden. Nach dem Abkühlen werden die Tabletten in den Tiegel einer Elektronenstrahl- Verdampfereinrichtung einer Aufdampfanlage vom Typ A700Q der Fa. Leybold eingebracht. In die Substrathaltevorrichtung der Anlage werden gereinigte Substrate aus Quarzglas und Brillenkronglas BK7 eingesetzt. Die Anlage wird auf einen Druck von 2x10⁻³ Pa evakuiert. Die Substrate werden auf etwa 300 °C aufgeheizt. Danach wird Sauerstoff bis zu einem Druck von 2x10⁻² Pa in die Anlage eingelassen. Die Tablette aus dem Aufdampfmaterial wird anschließend auf die Verdampfungstemperatur von etwa 2100 °C aufgeheizt und eine Schicht mit einer Dicke von etwa 240 nm auf die Substrate aufgedampft. Nach dem Abkühlen der Anlage wird mit Luft geflutet und die beschichteten Substrate werden entnommen. Mit einem Spektralphotometer werden die Transmissions- und Reflexionsspektren gemessen und aus diesen die Schichtdicke und die Brechzahl rechnerisch ermittelt. Die aufgebrachten Schichten sind homogen und weisen bei einer Wellenlänge von 500 nm eine Brechzahl von 1,71 auf. Die Absorption im Bereich von 300 bis 900 nm wird mit kleiner als 1 % festgestellt.

### Beispiel 4:

### Mischung aus Al₂O₃ und Yb₂O₃

14,46 g Aluminiumoxid (40 Mol. %) und 83,65 g Ytterbiumoxid (60 Mol. %) werden innig miteinander vermischt, bis ein homogenes Gemisch entstanden ist. Dieses Gemisch wird zu Tabletten geformt, welche an Luft bei 1300 °C 4 Stunden lang geglüht werden. Die Tabletten werden nach dem Abkühlen in den Tiegel einer Elektronenstrahl- Verdampfereinrichtung in einer Aufdampfanlage vom Typ A700Q der Fa. Leybold eingebracht. In die Substrathaltevorrichtung der Anlage werden gereinigte Substrate aus Quarzglas und Brillenkronglas BK7 eingesetzt. Die Anlage wird auf einen Druck von 2x10⁻³ Pa evakuiert. Die Substrate werden auf etwa 300 °C aufgeheizt. Danach wird Sauerstoff bis zu einem Druck von 2x10⁻² Pa in die Anlage eingelassen. Die Tablette aus dem Aufdampfmaterial wird anschließend auf die Verdampfungstemperatur von etwa 2100 °C aufgeheizt und eine Schicht mit einer Dicke von etwa 240 nm auf die Substrate aufgedampft. Nach dem Abkühlen der Anlage wird mit Luft geflutet und die beschichteten Substrate werden entnommen. Mit einem Spektralphotometer werden die Tränsmissions- und Reflexionsspektren gemessen und aus diesen die Schichtdicke und die Brechzahl rechnerisch ermittelt. Die aufgebrachten Schichten sind homogen und weisen bei einer Wellenlänge von 500 nm eine Brechzahl von 1,80 auf. Die Absorption im Bereich von 300 bis 900 nm wird mit kleiner als 1 % festgestellt.

### Beispiel 5:

### Mischung aus Al₂O₃, Dy₂O₃ und Gd₂O₃

21,7 Gew. % (50 Mol. %) Aluminiumoxid, 39,69 Gew. % (25 Mol. %) Dysprosiumoxid und 38,57 Gew. % (25 Mol. %) Gadoliniumoxid werden innig miteinander vermischt, bis ein homogenes Gemisch entstanden ist. Dieses Gemisch wird zu Tabletten geformt, welche an Luft bei 1500°C 4 Stunden lang geglüht werden. Die Tabletten werden nach dem Abkühlen in den Tiegel einer Elektronenstrahl- Verdampfereinrichtung in einer Aufdampfanlage vom Typ L560 der Fa. Leybold eingebracht. In die Substrathaltevorrichtung der Anlage werden gereinigte Substrate aus Quarzglas und Brillenkronglas BK7 eingesetzt. Die Anlage wird auf einen Druck von 2x10⁻³ Pa evakuiert. Die Substrate werden auf etwa 250 °C aufgeheizt. Danach wird Sauerstoff bis zu einem Druck von 2x10⁻² Pa in die Anlage eingelassen. Die Tablette aus dem Aufdampfmaterial wird anschließend auf die Verdampfungstemperatur von etwa 2100 °C aufgeheizt und eine Schicht mit einer Dicke von etwa 270 nm auf die Substrate aufgedampft. Nach dem Abkühlen der Anlage wird mit Luft ' geflutet und die beschichteten Substrate werden entnommen. Mit einem Spektralphotometer werden die Transmissions- und Reflexionsspektren gemessen und aus diesen die Schichtdicke und die Brechzahl rechnerisch ermittelt. Die aufgebrachten Schichten sind homogen und weisen bei einer Wellenlänge von 500 nm eine Brechzahl von 1,72 auf. Die Absorption im Bereich von 300 bis 900 nm wird mit kleiner als 1 % festgestellt.

### Beispiel 6:

### Mischung aus Al₂O₃, Dy₂O₃, Gd₂O₃ und Yb₂O₃

21,31 Gew. % (50 Mol. %) Aluminiumoxid, 25,97 Gew. % (16,66 Mol. %) Dysprosiumoxid und 25,42 Gew. % (16,66 Mol. %) Gadoliniumoxid und 27,47 Gew. % (16,68 Mol %) Ytterbiumoxid werden innig miteinander vermischt, bis ein homogenes Gemisch entstanden ist. Dieses Gemisch wird zu Tabletten geformt, welche an Luft bei 1500°C 6 Stunden lang geglüht werden. Die Tabletten werden nach dem Abkühlen in den Tiegel einer Elektronenstrahl- Verdampfereinrichtung in einer Aufdampfanlage vom Typ L560 der Fa. Leybold eingebracht. In die Substrathaltevorrichtung der Anlage werden gereinigte Substrate aus Quarzglas und Brillenkronglas BK7 eingesetzt. Die Anlage wird auf einen Druck von 2x10⁻³ Pa evakuiert. Die Substrate werden auf etwa 250 °C aufgeheizt. Danach wird Sauerstoff bis zu einem Druck von 2x10⁻² Pa in die Anlage eingelassen. Die Tablette aus dem Aufdampfmaterial wird anschließend auf die Verdampfungstemperatur von etwa 2100 °C aufgeheizt und eine Schicht mit einer Dicke von etwa 290 nm auf die Substrate aufgedampft. Nach dem Abkühlen der Anlage wird mit Luft geflutet und die beschichteten Substrate werden entnommen. Mit einem Spektralphotometer werden die Transmissions- und Reflexionsspektren gemessen und aus diesen die Schichtdicke und die Brechzahl rechnerisch ermittelt. Die aufgebrachten Schichten sind homogen und weisen bei einer Wellenlänge von 500 nm eine Brechzahl von 1,73 auf. Die Absorption im Bereich von 300 bis 900 nm wird mit kleiner als 1 % festgestellt.

Haltbarkeitstest:
Die in den Beispielen 1 bis 4 erhaltenen beschichteten Substrate wurden verschiedenen Haltbarkeitstests unterzogen. Dabei wurden die Substrate in verschiedenen Medien unter unterschiedlichen Bedingungen gelagert.

| Lagerung in: | Bedingung: |
|---|---|
| voll entsalztem (VE) Wasser | 6 Stunden bei Raumtemperatur |
| Kochendes VE-Wasser | 10 Minuten |
| Kochsalzlösung | 4,5 Gew. % in VE- Wasser, 6 Stunden, Raumtemperatur |
| Salzsäurelösung | 0,01 molar, 6 Stunden bei Raum-temperatur (pH 2) |
| Natronlaugelösung | 0,01 molar, 6 Stunden bei Raum-temperatur (pH 12) |

Ergebnisse: Bei keinem der Mustergläser ist nach dem jeweiligen Test eine Ablösung der aufgebrachten Schicht zu beobachten. Flecken und/oder Trübungen sind nicht feststellbar.

Untersuchung der Transmissions- und Reflexionsspektren:
Für die in den Beispielen 1 bis 4 erhaltenen beschichteten Substrate sowie eine Vergleichsprobe, welche aus einem mit Al₂O₃ beschichteten Quarzglas-Substrat bestand, wurden nach den oben genannten Haltbarkeitstests die Transmissions- und Reflexionsspektren bestimmt und im Vergleich zu den Transmissions- und Reflexionsspektren der nicht getesteten Substrate bewertet. Es ergaben sich folgende Ergebnisse:

| Test | Substanz. | | | |
|---|---|---|---|---|
| | Al₂O₃/Yb₂O₃ | Al₂O₃/Dy₂O₃ | Al₂O₃/Gd₂O₃ | Al₂O₃ |
| VE-Wasser | + | + | + | + |
| Kochtest | + | + | + | - |
| NaCl-Lösung | + | + | + | + |
| HCl-Lösung | - | + | ? | ? |
| NaOH-Lösung | + | + | + | - |

| | | | | |
|---|---|---|---|---|
| + Spektren unverändert - Spektren stark verändert ? spektren etwas verändert | | | | |

Nach diesen Ergebnissen zeigen Schichten aus Al₂O₃/Dy₂O₃ die besten Ergebnisse hinsichtlich ihrer mechanischen Haltbarkeit und der \/eränderlichkeit der Spektren nach Belastung in feucht-warmer Umgebung oder durch Säuren und Alkalien. Sie sind insbesondere besser haltbar als Schichten aus reinem Al₂O₃. Die Schichten mit Anteilen an Ytterbiumoxid und Gadoliniumoxid sind etwas weniger gut haltbar als die Schichten aus Al₂O₃/Dy₂O₃, jedoch deutlich besser als Schichten aus reinem Al₂O₃.

## Patentansprüche

1. Verwendung eines Aufdampfmaterials enthaltend Aluminiumoxid und mindestens eine Verbindung aus der Gruppe bestehend aus Gadoliniumoxid, Dysprosiumoxid und Ytterbiumoxid zur Herstellung von haftfesten mittelbrechenden optischen Schichten auf Glas- oder Kunststoffsubstraten.

2. Verwendung gemäß Anspruch 1, wobei das Aufdampfmaterial Aluminiumoxid und eine Verbindung aus der Gruppe bestehend aus Gadoliniumoxid, Dysprosiumoxid und Ytterbiumoxid enthält.

3. Verwendung gemäß Anspruch 1, wobei das Aufdampfmaterial Aluminiumoxid und zwei Verbindungen aus der Gruppe bestehend aus Gadoliniumoxid, Dysprosiumoxid und Ytterbiumoxid enthält.

4. Verwendung gemäß Anspruch 1, wobei das Aufdampfmaterial Aluminiumoxid und Gadoliniumoxid, Dysprosiumoxid und Ytterbiumoxid enthält.

5. Verwendung gemäß Anspruch 1 oder 2, wobei das Aufdampfmaterial Aluminiumoxid und Dysprosiumoxid enthält.

6. Verwendung gemäß einem der Ansprüche 1, 2 oder 5 wobei das Aufdampfmaterial Aluminiumoxid und eine Verbindung aus der Gruppe bestehend aus Gadoliniumoxid, Dysprosiumoxid und Ytterbiumoxid im Verhältnis von 1:99 bis 99:1 Mol. % enthält.

7. Verwendung gemäß einem der Ansprüche 1, 2, 5 oder 6, wobei das Aufdampfmaterial 20 bis 80 Mol % Aluminiumoxid und 80 bis 20 Mol
% mindestens einer Verbindung aus der Gruppe bestehend aus Gadoliniumoxid, Dysprosiumoxid und Ytterbiumoxid enthält.

8. Verfahren zur Herstellung eines Aufdampfmaterials zur Herstellung von haftfesten mittelbrechenden optischen Schichten auf Glas- oder Kunststoffsubstraten, wobei Aluminiumoxid mit Ytterbiumoxid und Gadoliniumoxid und/oder Dysprosiumoxid gemischt, die Mischung komprimiert oder suspendiert, geformt und anschließend gesintert wird.

9. Verfahren gemäß Anspruch 8, wobei das Sintern unter Lufteinfluss bei einer Temperatur von 1300 bis 1600 °C stattfindet.

10. Verfahren gemäß einem oder mehreren der Ansprüche 8 bis 9, wobei das Sintern im Vakuum oder unter Inertgas bei einer Temperatur von 1300 bis 1600°C stattfindet.

11. Verfahren gemäß einem oder mehreren der Ansprüche 8 bis 10, wobei die Mischung zu Tabletten, Pellets, Scheiben, Kegelstümpfen, Körnern, Granulaten, Stangen oder Kugeln geformt wird.

12. Aufdampfmaterial, zur Herstellung von haftfesten mittelbrechenden optischen Schichten auf Glas- oder Kunststoffsubstraten, enthaltend Aluminiumoxid und mindestens zwei Verbindungen us der Gruppe bestehend aus Gadoliniumoxid, Dysprosiumoxid und Ytterbiumoxid.

13. Aufdampfmaterial gemäß Anspruch 12, enthaltend Aluminiumoxid, Gadoliniumoxid, Dysprosiumoxid und Ytterbiumoxid.

14. Haftfeste mittelbrechende optische Schicht auf einem Glas- oder Kunststoffsubstrat mit einer Brechzahl im Bereich von 1,6 und 1,9, hergestellt unter Verwendung eines Aufdampfmaterials gemäß einem der Ansprüche 1 bis 7.

15. Mehrlagiges optisches System auf einem Glas- oder Kunststoffsubstrat, umfassend mindestens eine haftfeste mittelbrechende optische Schicht mit einer Brechzahl im Bereich von 1,6 bis 1,9, hergestellt unter Verwendung eines Aufdampfmaterials gemäß einem der Ansprüche 1 bis 7.

## Claims

1. Use of a vapour-deposition material comprising aluminium oxide and at least one compound from the group consisting of gadolinium oxide, dysprosium oxide and ytterbium oxide for the production of adherent optical layers of medium refractive index on glass or plastic substrates.

2. Use according to Claim 1, where the vapour-deposition material comprises aluminium oxide and a compound from the group consisting of gadolinium oxide, dysprosium oxide and ytterbium oxide.

3. Use according to Claim 1, where the vapour-deposition material comprises aluminium oxide and two compounds from the group consisting of gadolinium oxide, dysprosium oxide and ytterbium oxide.

4. Use according to Claim 1, where the vapour-deposition material comprises aluminium oxide and gadolinium oxide, dysprosium oxide and ytterbium oxide.

5. Use according to Claim 1 or 2, where the vapour-deposition material comprises aluminium oxide and dysprosium oxide.

6. Use according to one of Claims 1, 2 or 5, where the vapour-deposition material comprises aluminium oxide and a compound from the group consisting of gadolinium oxide, dysprosium oxide and ytterbium oxide in the ratio of 1:99 to 99:1 mol%.

7. Use according to one of Claims 1, 2, 5 or 6, where the vapour-deposition material comprises 20 to 80 mol% of aluminium oxide and 80 to 20 mol% of at least one compound from the group consisting of gadolinium oxide, dysprosium oxide and ytterbium oxide.

8. Process for the preparation of a vapour-deposition material for the production of adherent optical layers of medium refractive index on glass or plastic substrates, in which aluminium oxide is mixed with ytterbium oxide and gadolinium oxide and/or dysprosium oxide, and the mixture is compressed or suspended, shaped and subsequently sintered.

9. Process according to Claim 8, in which the sintering is carried out at a temperature of 1300 to 1600°C with inflow of air.

10. Process according to one or more of Claims 8 to 9, in which the sintering is carried out at a temperature of 1300 to 1600°C in vacuo or under inert gas.

11. Process according to one or more of Claims 8 to 10, in which the mixture is shaped to give tablets, pellets, discs, truncated cones, grains, granules, rods or beads.

12. Vapour-deposition material for the production of adherent optical layers of medium refractive index on glass or plastic substrates, comprising aluminium oxide and at least two compounds from the group consisting of gadolinium oxide, dysprosium oxide and ytterbium oxide.

13. Vapour-deposition material according to Claim 12, comprising aluminium oxide, gadolinium oxide, dysprosium oxide and ytterbium oxide.

14. Adherent optical layer of medium refractive index on a glass or plastic substrate having a refractive index in the range from 1.6 to 1.9, produced using a vapour-deposition material according to one of Claims 1 to 7.

15. Multilayered optical system on a glass or plastic substrate, comprising at least one adherent optical layer of medium refractive index having a refractive index in the range from 1.6 to 1.9, produced using a vapour-deposition material according to one of Claims 1 to 7.

## Revendications

1. Utilisation d'un matériau de dépôt en phase vapeur comprenant de l'oxyde d'aluminium et au moins un composé pris à partir du groupe constitué de oxyde de gadolinium, oxyde de dysprosium et oxyde d'ytterbium pour la production de couches optiques adhérentes d'indice de réfraction moyen sur des substrats en verre ou en plastique.

2. Utilisation selon la revendication 1, dans laquelle le matériau de dépôt en phase vapeur comprend de l'oxyde d'aluminium et un composé pris parmi le groupe constitué de oxyde de gadolinium, oxyde de dysprosium et oxyde d'ytterbium.

3. Utilisation selon la revendication 1, dans laquelle le matériau de dépôt en phase vapeur comprend de l'oxyde d'aluminium et deux composés pris parmi le groupe constitué de oxyde de gadolinium, oxyde de dysprosium et oxyde d'ytterbium.

4. Utilisation selon la revendication 1, dans laquelle le matériau de dépôt en phase vapeur comprend de l'oxyde d'aluminium et de l'oxyde de gadolinium, de l'oxyde de dysprosium et de l'oxyde d'ytterbium.

5. Utilisation selon la revendication 1 ou 2, dans laquelle le matériau de dépôt en phase vapeur comprend de l'oxyde d'aluminium et de l'oxyde de dysprosium.

6. Utilisation selon l'une des revendications 1, 2 ou 5, dans laquelle le matériau de dépôt en phase vapeur comprend de l'oxyde d'aluminium et un composé pris parmi le groupe constitué de oxyde de gadolinium, oxyde de dysprosium et oxyde d'ytterbium dans le rapport de 1:99 à 99:1 % molaire.

7. Utilisation selon l'une des revendications 1, 2, 5 ou 6, dans laquelle le matériau de dépôt en phase vapeur comprises 20 à 80 % molaire d'oxyde d'aluminium et 80 à 20 % molaire d'au moins un composé pris parmi le groupe constitué de oxyde de gadolinium, oxyde de dysprosium et oxyde d'ytterbium.

8. Procédé pour la préparation d'un matériau de dépôt en phase vapeur pour la production de couches optiques adhérentes d'indice de réfraction moyen sur des substrats en verre ou en plastique, dans lequel de l'oxyde d'aluminium est mélangé avec de l'oxyde d'ytterbium et de l'oxyde de gadolinium et/ou de l'oxyde de dysprosium, et le mélange est comprimé ou mis en suspension, conformé et ensuite fritté.

9. Procédé selon la revendication 8, dans lequel le frittage est mis en oeuvre à une température de 1300 à 1600°C avec injection d'un courant d'air.

10. Procédé selon l'une des revendications 8 à 9, dans lequel le frittage est mis en oeuvre à une température de 1300 à 1600°C dans le vide ou sous gaz inerte.

11. Procédé selon une ou plusieurs des revendications 8 à 10, dans lequel le mélange est conformé pour donner des tablettes, des pastilles, des disques, des cônes tronqués, des grains, des granulés, des barreaux ou des perles.

12. Matériau de dépôt en phase vapeur pour la production de couches optiques adhérentes d'indice de réfraction moyen sur des substrats en verre ou en plastique, comprenant de l'oxyde d'aluminium et au moins deux composés pris parmi le groupe constitué de oxyde de gadolinium, oxyde de dysprosium et oxyde d'ytterbium.

13. Matériau de dépôt en phase vapeur selon la revendication 12, comprenant de l'oxyde d'aluminium, de l'oxyde de gadolinium, de l'oxyde de dysprosium et de l'oxyde d'ytterbium.

14. Couche optique adhérente d'indice de réfraction moyen sur un substrat en verre ou en plastique ayant un indice de réfraction dans la plage de 1,6 à 1,9, produite en utilisant un matériau de dépôt en phase vapeur selon l'une des revendications 1 à 7.

15. Système optique multicouche sur un substrat en verre ou en plastique, comprenant au moins une couche optique adhérente d'indice de réfraction moyen ayant un indice de réfraction dans la plage de 1,6 à 1,9, produite en utilisant un matériau de dépôt en phase vapeur selon l'une des revendications 1 à 7.
